(19) Europäisches Patentamt
European Patent Office
Office européen des brevets

(11) Veröffentlichungsnummer: **0 039 800**
**A1**

(12) # EUROPÄISCHE PATENTANMELDUNG

(21) Anmeldenummer: 81102967.7

(22) Anmeldetag: 16.04.81

(51) Int. Cl.³: G 11 C 15/00

(30) Priorität: 08.05.80 DE 3017700

(43) Veröffentlichungstag der Anmeldung: 18.11.81 Patentblatt 81/46

(84) Benannte Vertragsstaaten: DE FR GB

(71) Anmelder: SIEMENS AKTIENGESELLSCHAFT Berlin und München
Postfach 22 02 61
D-8000 München 22(DE)

(72) Erfinder: Brunner, Reinhold, Dipl.-Ing.
Kafkastrasse 7a
D-8000 München 83(DE)

(72) Erfinder: Bromme, Irmfried, Dipl.-Ing.
Midgardstrasse 9a
D-8000 München 83(DE)

(72) Erfinder: Wagner, Wolfgang, Dipl.-Ing.
Wachenheimer Strasse 15
D-8000 München 90(DE)

(54) **Monolithisch integrierbare digitale Komparatorschaltung.**

(57) Für die Auswertung von in digitalen Archiven gespeicherten Informationen ist es üblich, die Suche nach den gespeicherten Informationen mittels einer durch digitale Erkennungssignale einerseits und durch das digitale Datenarchiv andererseits zu beaufschlagenden Komparatorschaltung vorzunehmen. Es ist nun Aufgabe der Erfindung, einen Ersatz für die üblichen Komparatorschaltungen anzugeben, welche vor allem gegenüber den bisher bekannten Möglichkeiten einen beschleunigten Ablauf des Suchvorgangs ermöglicht. Hierzu wird vorgeschlagen, daß jede Zelle des das digitale Archiv bildenden Matrixspeichers (DKS) jeweils mit je einem eine Komparatorzelle bildenden Schaltungsteil (T9, T10, T7, T8) kombiniert ist. Außerdem wird vorgeschlagen, daß dabei die Signalausgänge (KA) der Komparatorzellen der einzelnen Matrixzeilen (Zi) jeweils an einen gemeinsamen, der betreffenden Matrixzeile jeweils zugeordneten Signalausgang (KZi) gelegt ist.

FIG 2

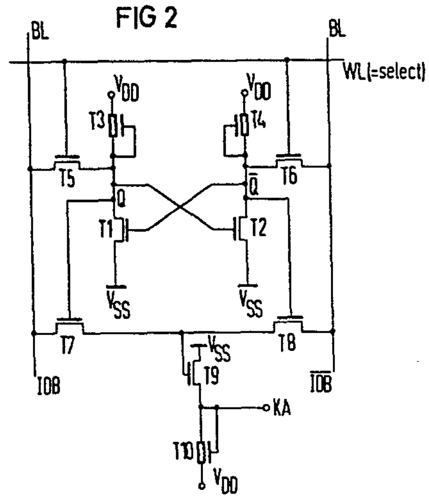


EP 0 039 800 A1

Croydon Printing Company Ltd.

Siemens Aktiengesellschaft
Berlin und München

Unser Zeichen
VPA 80 P 1065 E

Monolithisch integrierbare digitale Komparatorschaltung

Die Erfindung bezieht sich auf eine monolithisch integrierbare digitale Komparatorschaltung zum Vergleich von extern in die Schaltung eingegebenen Digitalsignalen mit in einem zu der Schaltung gehörenden Matrixspeicher festgehaltenen Digitalsignalen und einem den Vergleich vornehmenden Komparator.

Solche Schaltungen sind in der Datenverarbeitung üblich. Sie werden vor allem dann verwendet, wenn eingegangene Binärworte in Digitalarchiven ausfindig gemacht werden sollen.

Solche Suchvorgänge in Dateien und Datenströmen werden z.B. in der EDV (= elektronische Datenverarbeitung), der Text- bzw. Wortverarbeitung und in der Datenübertragung häufig durch aufwendige Hardware, z.B. in ECL-Technologie, und /oder durch Software abgewickelt, wobei häufige Suchvorgänge zu einer starken Belastung der Anlage, d.h. des verwendeten Prozessors, führen. Zur Reduktion der Belastung des Prozessors bzw. des Softwareaufwands bzw. des Hardwareaufwands und zur Erzielung höherer Datendurchsatzraten beim Suchen empfiehlt es sich, eine Unterstützung des Suchvorganges durch entsprechend ausgelegte und weitgehend autonom arbeitende hochintegrierte MOS-Bausteine anzustreben.

Eine in einem solchen MOS-Baustein vorzusehende Komparatorschaltung kann in der aus Fig. 1 ersichtlichen Weise aufgebaut sein. Der Komparator K wird einerseits durch das am externen Dateneingang DE liegende Digitalwort beaufschlagt und die Beaufschlagung dort solange aufrecht erhalten, bis der Vergleich dieses externen Signals mit den im Speicher DS festgehaltenen Digitalworten abgeschlossen ist bzw. zu einem positiven Ergebnis geführt hat. Die im Speicher DS festgehaltenen Informationen werden über den Adreßdekoder AD durch die aus dem Adreßregister AR aufgerufenen Signale aus dem Speicher DS an den Komparator K gelegt und dort mit dem externen Digitalwort verglichen. Der Speicher DS ist insbesondere als Schreib-Lesespeicher, also als RAM-Speicher, ausgebildet. Die vom Komparator K gelieferten Vergleichsergebnisse werden einer Auswerte-Logik AL zugeführt, deren Signalausgang mit SA bezeichnet ist.

Aufgabe der Erfindung ist es nun, eine der eingangs gegebenen Definition entsprechende digitale Komparatorschaltung so auszugestalten, daß das Vergleichsergebnis rascher als bei den bisher bekannten Schaltungen dieser Art gewonnen und ausgewertet werden kann.

Erfindungsgemäß wird hierzu vorgeschlagen, daß die in an sich bekannter Weise als einander gleiche bistabile Kippstufen ausgebildeten Speicherzellen des Matrixspeichers jeweils mit je einem eine Komparatorzelle bildenden Schaltungsteil kombiniert sind und daß die Signalausgänge der Komparatorzellen der einzelnen Matrixzeilen jeweils an einen gemeinsamen, der betreffenden Ma-Matrixzeile jeweils zugeordneten Signalausgang der auf diese Weise erhaltenen Speicher-Komparator-Kombination gelegt ist.

Die Erfindung wird nun anhand der Fig. 2 - 4 näher beschrieben. Dabei stellen Fig. 2 und Fig. 3 je eine Speicher-Komparatorzelle gemäß der Erfindung dar, während in Fig. 4 ein Blockschaltbild der erfindungsgemäßen Vergleichsschaltung in einer besonders vorteilhaften Ausführungsform dargestellt ist.

Die in Fig. 2 dargestellte Kombination einer RAM-Speicherzelle mit einer Komparatorzelle besteht aus einem durch die beiden kreuzgekoppelten MOS-Transistoren T1 und T2 vom Anreicherungstyp bestehenden Flip-Flop als Speicherzelle. Die Drainanschlüsse der beiden Transistoren T1 und T2 der Flip-Flopzelle liegen über je eine durch je einen - z.B. als MOS-Transistor vom Verarmungstyp ausgebildeten - Feldeffekttransistor T3 bzw. T4 an dem gemeinsamen ersten Versorgungspotential $V_{DD}$ und über ihre Sourceanschlüsse an dem zweiten gemeinsamen und als Masse geschalteten Versorgungspotential $V_{SS}$. Ein zwischen den beiden Transistoren T1 und T3 bzw. T2 und T4 befindlicher Schaltungspunkt liegt über die Source-Drainstrecke je eines weiteren MOS-Transistors T5 bzw. T6 vom Anreicherungstyp an je einer der beiden die betreffende Zelle schaltenden Bit-Leitungen BL, während das Gate der beiden zuletzt genannten Transistoren T5 und T6 gemeinsam an einer zeilenparallel verlaufenden Wort-Adressierleitung WL angelegt ist. Die genannten Transistoren sind in der Regel vom selben Kanaltyp, insbesondere vom n-Kanaltyp.

Es handelt sich also bei der in Fig. 2 dargestellten Speicherzelle um eine statische 6-Transistor-Speicherzelle, wobei die Transistoren T1, T2, T5 und T6 als Transistoren vom Anreicherungstyp und die beiden Last-Lasttransistoren T3 und T4 als Verarmungstyp-Transistoren ausgebildet sind.

Entsprechend der Erfindung sind nun die beiden Signalausgänge Q und $\overline{Q}$ (d.h. also die Drainanschlüsse der beiden kreuzgekoppelten Transistoren T1 und T2) zu Steuerung je eines Eingangs des der betreffenden Speicherzelle jeweils zugeordneten Komparator-Schaltungsteils vorgesehen.

Hierzu sind die beiden zur Steuerung der 6-Transistor-Speicherzelle vorgesehenen Bit-Leitungen BL über die Source-Drain-Strecke je eines weiteren Transistors vom Typ der Transistoren T1, T2, T5 und T6 an das Gate eines weiteren Transistors T9 vomselben Typ gelegt. Der Transistor T9 ist mit seinem Source-Anschluß mit Masse, also dem Potential $V_{SS}$, und mit seinem Drain-Anschluß über einen Lasttransistor vom Typ der Lasttransistoren T3 und T4 mit dem ersten Betriebspotential $V_{DD}$ verbunden. Der Drain-Anschluß des Transistors T9 im Komparatorteil bildet außerdem den Komparatorausgang der betreffenden Speicher-Komparatorzelle gemäß Fig. 2.

Die in Fig. 3 dargestellte kombinierte Speicher-Komparator-Zelle unterscheidet sich von der Speicher-Komparator-Zelle gemäß Fig. 2 lediglich durch zwei zusätzliche Transistoren T11 und T12 vom Typ der kreuzgekoppelten Transistoren T1 und T2, deren Drain - ebenso wie der Drain des Transistors T5 bzw. T6-am Ausgang Q bzw. $\overline{Q}$ des die Speicherzelle bildenden Flip-Flops liegen, während der Source-Anschluß des Transistors T11 bzw. des Transistors T12 mit je einer weiteren, zur Adressierung bzw. Stromversorgung der betreffenden Zelle dienenden Bit-Leitung BL verbunden ist. Die Gates der beiden zusätzlichen Transistoren T11 und T12 liegen an einer gemeinsamen zweiten Wortleitung $WL^*$.

Die Betriebs- und Wirkungsweise der in Fig. 2 und Fig. 3 dargestellten Zellen ist, wie folgt:

Da es sich zunächst darum handelt, den als RAM-Speicher zu betreibenden Speicher DKS (Fig.4), von dem die einzelne Zelle gem. Fig. 2 bzw. Fig. 3 nur einen Teil unter vielen - einander gleichen - Teilen bildet, mit der für den Vergleich heranzuziehenden Dateninformation zu beladen, wird die zeilenweise einzuspeichernde Information unmittelbar an je eine der beiden für die Informationsversorgung der betreffenden Zelle vorgesehene Bit-Leitung BL und im invertierten Zustand (d.h. also unter Vermittlung eines (nicht dargestellten) Inverters) an die andere der betreffenden Zelle zugeordnete Bit-Leitung BL gelegt. Die mit der direkten Information zu beaufschlagende Bit-Leitung BL ist zur Darstellung ihrer soeben genannten Funktion zusätzlich mit IDB (= interner Daten- Bus) und die andere mit $\overline{IDB}$ bezeichnet. Damit ist die betrachtete Zelle über ihre beiden Bitleitungen IDB und $\overline{IDB}$ in derselben Weise wie die übrigen zu derselben Matrixspalte wie die betrachtete Zelle gehörenden Zellen beaufschlagt. Die Freigabe der betreffenden Zelle für die Informationsaufnahme wird durch ein an die der betreffenden Zelle und damit der die betreffende Zelle enthaltenden Matrixzeile zugeordneten und parallel zu dieser verlaufenden Auswahlleitung WL gelegtes Adressiersignal (vom Adressier-Dekoder AD stammend) bewirkt

Entsprechend der Beaufschlagung durch die beiden informationsführenden Bit-Leitungen IDB und $\overline{IDB}$ stellt sich bei den jeweils adressierten Zellen der Betriebszustand ihres Speicher-Flip-Flops ein, so daß am direkten Ausgang Q der dem gespeicherten Signal entsprechende logische Zustand und am invertierten Ausgang $\overline{Q}$ der dem gespeicherten Signal entsprechende invertierte logische Zustand abnehmbar ist. Der Betriebszustand des Flip-Flops, also der Transistoren T1 und T2 der Zelle, wird durch den Vergleich mit der extern zuzuführenden Information nicht beeinflußt.

Ist unter den soeben angegebenen Voraussetzungen in die Zelle gem. Fig. 1 eine "1" eingespeichert, dann liegt am Ausgang Q und damit am Gate des Transistors T7 eine "1", so daß dieser Transistor für die über die Bit-Leitung IDB zugeführte externe Information geöffnet ist, während eine "0" am Ausgang Q den Transistor T7 gegen das externe Signal sperrt. Ist somit das externe Signal als auch das in der betreffenden Zelle gespeicherte Bit eine "1", so gelangt der Zustand "1" an das Gate des Anreicherungstransistors T9 und damit an den Eingang des Inverters T9, T10, so daß an dessen Ausgang KA eine "0" gegeben wird.

Ist andererseits bei einer gespeicherten "1" der vom externen Signal stammende Zustand IDB gleich "0", so ist, weil der Transistor T8 über den Ausgang $\overline{Q}$ gesperrt ist, der Zustand am Gate des Transistors T9 und damit am Eingang des Inverters T9, T10 gleich "0". Die Folge davon ist eine "1" am Ausgang KA der Zelle.

Ist weiterhin der Speicherinhalt der Zelle gleich "0" und somit am Ausgang Q sowie am Gate des Transistors T7 eine "0" anhängig, so ist der Transistor T7 gesperrt und der Transistor T8 geöffnet. Da die externe Information über die Bit-Leitung IDB den einzelnen Zellen zugeführt wird und außerdem die invertierte externe Information an der anderen Bit-Leitung $\overline{IDB}$ liegt, gelangt dann die jeweils vorliegende inverte externe Information über den Transistor T8 an den Eingang des Inverters T9, T10 und bestimmt den logischen Zustand am Ausgang KA der betreffenden Zelle.

Unter den soeben genannten Voraussetzungen gibt der Ausgang KA des Inverters T9, T10 eine "1", wenn eine "0" gespeichert und an der Bit-Leitung IDB eine "1" anhängig ist, während eine "0" an der Bit-Leitung IDB dann zu einer "0" am Ausgang KA führen muß.

Man hat also das aus folgender Tabelle ersichtliche Verhalten, wobei die Bit-Leitung IDB das externe Signal und die Bit-Leitung $\overline{IDB}$ das invertierte Signal führt.

| IDB | $\overline{IDB}$ | Q | $\overline{Q}$ | KA |
|---|---|---|---|---|
| "1" | "0" | "1" | "0" | "0" |
| "0" | "1" | "1" | "0" | "1" |
| "1" | "0" | "0" | "1" | "1" |
| "0" | "1" | "0" | "1" | "0" |

also

| IDB | Q | KA |
|---|---|---|
| "1" | "1" | "0" |
| "0" | "1" | "1" |
| "1" | "0" | "1" |
| "0" | "0" | "0" |

Die in Fig. 2 dargestellte Zelle verhält sich also wie ein Exklusiv-ODER-Gatter inbezug auf den logischen Zustand am Ausgang Q des Flip-Flops und das an der Bit-Leitung IDB liegende Bit des externen Datenworts. Eine "1" am Komparatorausgang KA der einzelnen Zelle besagt somit Ungleichheit zwischen dem Speicherinhalt des Flip-Flops und dem an der Bit-Leitung IDB anhängigen externen Bit.

Führt man in Abwandlung der soeben angegebenen Betriebsweise der beiden Bit-Leitungen die invertierte externe Information der Bit-Leitung IDB und die nicht invertierte Information der Bitleitung $\overline{IDB}$ zu, während die nichtinvertierte gespeicherte Information nach wie vor am Q-Ausgang des Flip-Flops anhängig ist, so hat man die Wirkung eines Äquivalenzgatters mit zwei Signaleingängen: d.h. bei Gleichheit der gespeicherten Information mit der externen Information erhält man am Ausgang KA eine "1", bei Ungleichheit hingegen eine "0".

Die in Fig. 3 dargestellte Ausgestaltung der die Komparator-Speicher-Kombination aufbauenden Zelle hat man pro Spalte der Matrix und damit pro Zelle jeweils vier Bit-Leitungen BL, die entsprechend der jeweils für sie vorgesehenen Betriebsweise zusätzlich mit IDBR, IDBW, $\overline{IDBR}$ und $\overline{IDBW}$ bezeichnet sind. Die Bitleitungen IDBR und $\overline{IDBR}$ dienen zum Auslesen der gespeicherten Information und führen das externe Signal, während die Bit-Leitungen IDBW und $\overline{IDBW}$ zum Einschreiben der zu speichernden Information bzw. zum Löschen der gespeicherten Information vorgesehen sind. Der Komparator-Betrieb der Zelle spielt sich in derselben Weise, wie an Hand von Fig. 2 gezeigt, ab. Die Auswahlleitung $WL^*$ dient zur Zeilenauswahl beim Einschreiben der zu speichernden Information und die Auswahlleitung WL zur Zeilenauswahl für den Vergleich. Die in Fig. 3 dargestellte Zelle ermöglicht bei einer auf ihrer Grundlage aufgebauten Matrix, daß die Matrix gleichzeitig mit neuer Information an einer Zeile beaufschlagt wird, während in einer anderen Zeile der Komparatorbetrieb mit der anhängigen externen Information stattfindet. Der Komparatorbetrieb findet in der bereits anhand von Fig. 2 beschriebenen Weise statt.

Eine aus kombinierten Speicher- Komparator-Zellen gemäß Fig.2 oder gemäß Fig. 3 aufgebaute Speichermatrix DKS ersetzt in der bekannten Schaltung gemäß Fig. 1 die beiden Schaltungsteile DS und K. Sie wird also einerseits durch einen Adreß-Dekoder AD und durch das externe Datensignal über einen Eingang DE gesteuert, während andererseits durch sie eine Auswerte-Logik AL beaufschlagt wird. Diese Matrix DKS ist pro Zeile neben den für den Speicherbetrieb erforderlichen Wortleitungen WL pro Zeile noch mit einer weiteren zeilenparallel verlaufenden Leitung versehen, über die die Ausgänge KA der der betreffenden Zeile angehörenden Zellen zusammengefaßt sind, so daß einer Steuerung der Auswerte-Logik AL durch die Komparator-Ausgänge der einzelnen Matrixzeilen nichts im Wege steht.

Eine entsprechende Ausgestaltung einer Komparatorschaltung gemäß der Erfindung sowie deren Weiterbildung wird nun anhand von Fig. 4 näher beschrieben. In dieser ist, wie in Fig. 1, die Darstellung der wesentlichen Teile im Blockschaltbild gewählt.

Der Hauptteil der in Fig. 4 dargestellten Anlage gemäß der Erfindung ist die aus Zellen gemäß Fig. 2 oder aus Zellen gemäß Fig. 3 aufgebaute Speicher-Komparator-Kombination DKS. Sie besteht aus N Zeilen und P Spalten. Dabei sind, wie oben bereits erwähnt, die Ausgänge KA der einzelnen Zellen in jeder Matrixzeile an einen der betreffenden Zeile jeweils zugeordneten gemeinsamen Ausgang $KZ_i$ gelegt, wobei der die betreffende Zeile angebende Index i von Null bis N-1 läuft.

Als Schaltungsvereinfachung ist dabei die Möglichkeit zu erwähnen, daß man für alle P Zellen pro Matrixzeile nur einen einzigen gemeinsamen Lasttransistor T10 vorsieht, so daß die in jeder Zelle vorgesehenen Transistoren T9 mit den Transistoren T9 der übrigen Zellen der betreffenden Zeile zu einem gemeinsamen NOR-Gatter mit P Eingängen vereint sind.

Zu bemerken ist außerdem, daß die Speicher-Komparator-Kombination DKS auch aus Speicherzellen anderer Art in Verbindung mit einem Inverter aufgebaut sein kann, sofern die einzelnen Speicherzellen einen das eingespeicherte Signal und einen das hierzu invertierte Signal führenden Ausgang Q bzw. $\overline{Q}$ aufweisen, sowie eine Anschaltung des Inverters in der aus Fig. 2 bzw. 3 ersichtlichen Weise an die externe Vergleichsinformation führende Bit-Leitungen IDB bzw. $\overline{IDB}$ möglich ist.

Jeder der Ausgänge $KZ_1$ bis $KZ_{N-1}$ der Anlage DKS (also der resultierende Vergleichsausgang jeder Matrixzeile $Z_i$ mit Ausnahme der ersten Matrixzeile $Z_o$) liegt an je einem Signaleingang der Auswerte-Logik AL.

Hierzu kann z.B. ein N Signaleingänge aufweisender Parallel-Serienwandler (also ein im Parallel-Serienbetrieb arbeitendes taktgesteuertes Schieberegister) vorgesehen sein, durch welchen die sich während je eines Vergleichszyklus an den Ausgängen $KZ_o$, $KZ_1$ - $KZ_{N-1}$ ergebenden logischen Zustände abgefragt und in ein dem betreffenden Abfragezyklus jeweils zugeordnetes Datenwort umgewandelt werden, mit dessen Hilfe die ein positives bzw. die ein negatives Vergleichsergebnis in dem betreffenden Zyklus liefernden Zeilen der Matrix DKS leicht festgestellt werden können. Bei der in Fig. 4 dargestellten Ausgestaltung einer Komparatorschaltung gemäß der Erfindung ist jedoch eine andere Ausgestaltung der Auswerte-Logik verwendet.

Jeder der Ausgänge $KZ_1$ bis $KZ_{N-1}$ der Anlage DKS ist bei der in Fig. 4 gezeigten Darstellung an den einen Eingang je eines UND-Gatters $U_i$ ( also $U_1$ bzw. $U_2$.....bzw. $U_{N-1}$ ) gelegt, während der resultierende Vergleichsausgang $KZ_o$ der ersten Matrixzeile $Z_o$ am Dateeingang einer Schieberegisterzelle $S_o$ liegt. Der Ausgang dieser Schieberegisterzelle $S_o$ ist einerseits mit dem anderen Eingang des durch die zweite Matrixzeile $Z_1$ über den Komparatorausgang $KZ_1$ beaufschlagten UND-Gatter $U_1$ und andererseits mit dem einen Eingang eines weiteren dem betreffenden

Vergleichsausgang $KZ_1$ zugeordneten UND-Gatters $A_1$ verbunden.

Der Ausgang des durch die Schieberegisterzelle $S_o$ und den Vergleichsausgang $KZ_1$ der zweiten Matrixzeile gesteuerten UND-Gatters $U_1$ liegt am Informationseingang einer weiteren Schieberegisterzelle $S_1$, die, da sie durch die Information aus der zweiten Matrixzeile $Z_1$ beaufschlagt ist, denselben Index wie die Bezeichnung dieser Matrixzeile $Z_1$ hat.

Der Ausgang der zuletzt genannten Schieberegisterzelle $S_1$ dient einerseits - zusammen mit dem Vergleichsausgang $KZ_2$ der dritten Matrixzeile $Z_2$ - zur Steuerung eines UND-Gatters $U_2$ und außerdem eines UND-Gatters $A_2$ (wobei das UND-Gatter $A_2$ im Gegensatz zu $U_2$ nicht durch $KZ_2$ beeinflußt ist.

Allgemein ist, da die Anschaltung aller Vergleichsausgänge $KZ_1$ bis $KZ_{N-1}$ der Matrix DKS übereinstimmend ist, festzustellen:

Der Vergleichsausgang $KZ_i$ liegt am einen Eingang eines UND-Gatters $U_i$, dessen anderer Eingang durch den Informationsausgang der durch den Vergleichsausgang $KZ_{i-1}$ über das UND-Gatter $U_{i-1}$ beaufschlagten Schieberegisterzelle $S_{i-1}$ gesteuert ist. Der Ausgang des durch den Ausgang $KZ_i$ gesteuerten UND-Gatters $U_i$ liegt am Informationseingang der dem betreffenden Vergleichsausgang $KZ_i$ von DKS jeweils zugeordneten Schieberegisterzelle $S_i$. Der Ausgang dieser Schieberegisterzelle $S_i$ dient zur Steuerung des einen Eingangs eines zweiten der Matrixzeile $Z_i$ und damit dem Ausgang $KZ_i$ zugeordneten UND-Gatters $A_i$. Er dient außerdem zur Mitsteuerung des der folgenden Matrixzeile $Z_{i+1}$ und deren Vergleichsausgang $KZ_{i+1}$ zugeordneten UND-Gatters $U_{i+1}$.

Einzelheiten über die Taktversorgung der Schieberegisterzellen $S_o$ bis $S_{N-1}$ werden noch gebracht. Dasselbe gilt für die an den jeweils anderen Eingang der UND-Gatter $A_i$ zu legenden Signale $D_i$.

Den Ausgang der Logikschaltung AL bildet in dem in Fig. 4 dargestellten Ausführungsbeispiel ein NOR-Gatter NOR, welches durch die einzelnen Ausgänge der durch die einzelnen Schieberegisterzellen $S_o$ bis $S_{N-1}$ gesteuerten UND-Gatter $A_i$ beaufschlagt ist.

Die Zeilenauswahlleitungen WL der Matrixzeilen $Z_o$ bis $Z_{N-1}$ werden vom Adreß-Dekoder AD her sowohl bei Schreibbetrieb als auch beim Lesebetrieb zwecks Adressierung der betreffenden Matrixzeile $Z_i$ durch ein Adressiersignal $D_i$ beaufschlagt. Während der Vergleichsphase beim Betrieb der Schaltung werden die jeweiligen Adressiersignale $D_i$ für die Beaufschlagung des zweiten Eingangs des jeweiligen UND-Gatters $A_i$ verwendet, während das Adressiersignal $D_i$ von der zum UND-Gatter $A_i$ gehörenden Matrixzeile $Z_i$ ferngehalten ist. Dies bedeutet, daß an der der Matrixzeile $Z_i$ zugeordneten Adressierleitung WL während der Vergleichsphase kein Signal anhängig ist. Eine Ausnahme bildet lediglich das Adressiersignal $D_o$, da der ersten Matrixzeile $Z_o$ kein solches UND-Gatter $A_i$ zugeordnet ist.

Für die Taktversorgung der Registerzellen $S_o$ bis $S_{N-1}$ ist ein in üblicher Weise ausgestalteter und deshalb in der Figur nicht berücksichtigter Taktgeber vorgesehen, der unter Berücksichtigung des Aufbaues der einander gleichen Schieberegisterzellen $S_o$ bis $S_{N-1}$ den für deren Betrieb erforderlichen Takt liefert. Zweckmäßig sind die Schieberegisterzellen $Z_i$ als Master-Slave-Flip-Flopzellen aufgebaut, so daß zwei gegeneinander in bekannter Weise phasenverschobene Folge TM und TS von Taktimpulsen derselben Frequenz in diesem Fall benötigt werden. Der Taktgeber kann auch für die Steuerung der Eindes zu vergleichenden externen Datenworts über die Bit-Leitungen IDB bzs. $\overline{IDB}$ herangezogen werden.

Das externe Datenwort enthält P Bits, die nach Maßgabe ihrer Anordnung im Datenwort an die das jeweilige Vergleichs-Bit enthaltende kombinierte Speicher-Komparator-Zelle der Matrix DKS über die zur Beaufschlagung der betreffenden Zelle vorgesehene Bit-Leitung IDB bzw. $\overline{IDB}$ gelegt werden und dort bis nach dem Abschluß des voll durchgeführten Vergleichs anhängig bleiben.

Der Adreß-Dekoder AD steht in an sich bekannter Weise mit einem Adreß-Register AR in Verbindung, welches die für die Adressierung der einzelnen Zeilen $Z_i$ der Matrix DKS erforderlichen Daten sowie Mittel zur Durchführung dieser Adressierung enthält. Beispielsweise kann hierbei der die Takte DG für die Schieberegisterzellen $S_i$ liefernde Taktgeber - ggf. unter Vermittlung von Zählern und Frequenzteilern - eingesetzt sein. Diesbezügliche Einzelheiten sind jedoch für die vorliegende Erfindung nicht von Wichtigkeit, so daß auf den einschlägigen Stand der Technik verwiesen werden kann.

Die vomselben Takt TG gemeinsam gesteuerten und einander gleichen Schieberegisterzellen $S_i$, z.B. Master-Slave-Flip-Flops, arbeiten folgendermaßen. Erhält die einzelne Schieberegisterzelle $S_i$ vom Ausgang des jeweils vorgeschalteten UND-Gatters $U_{i-1}$ eine "1", so wird mit dem nächsten Takt TG diese "1" an die folgende UND-Gatter $A_{i+1}$ und $U_{i+1}$ weitergegeben. Das UND-Gatter $A_{i+1}$ spricht aber nur dann an, wenn vom Adreß-Dekoder AD gleichzeitig das Adressiersignal $D_{i+1}$ vorliegt. Außerdem wird die "1" durch das UND-Gatter $U_{i+1}$ nur dann an die Schieberegisterzelle $S_{i+1}$ weitergegeben, wenn am Vergleichsausgang $ZK_{i+1}$ der Matrix eine "1" anhängig ist, also in einer der Zellen der Matrixzeile $Z_{i+1}$ eine Ungleichheit zwischen dem gespeicherten Bit und dem externen Bit festgestellt worden ist.

Die in Fig. 4 dargestellte Vorrichtung gemäß der Erfindung besteht im wesentlichen N Worte zu je P Bit umfassenden CAM-Speicher (= Content Adressable Memory), dessen Speicherzellen in der von der Erfindung vorgeschlagenen Weise ergänzt sind Weiter ist eine Auswerte-Logik AL in Verbindung mit N taktgesteuerten Schieberegisterzellen $S_i$ vorgesehen. Jedes Wort des CAM-Speichers besitzt eigene Adreß-Freigabeleitungen, die von einem oder zwei Adreß-Dekodern AD herkommen. Jedes Bit des CAM-Speichers (d.h. jede seiner Speicherzellen) besteht aus einem Speicher-Flip-Flop mit einem Vergleichsergänzungsteil, so daß die in der einzelnen Zelle gespeicherte Information mit dem jeweils für den Vergleich zugeteilten Bit des externen Datenworts gemäß einer EXOR-Funktion (bzw. einer Äquivalenz-Funktion) verglichen werden werden kann. Die Vergleichsausgänge KA aller P Bits des in der einzelnen Matrixzeile eingespeicherten Datenworts sind zum Ausgang $KZ_i$ zusammengefaßt. Schreiben oder Lesen eines im Speicher DKS festgehaltenen Datenworts erfolgt bei Aktiv-Pegel der betreffenden Adreß-Freigabeleitung WL der betreffenden Matrixzeile bei gleichzeitigem Aktiv-Pegel des Schreib/Daten-Gültig- oder Lesesignals. Im Schreibmodus werden Daten von der das externe Datenwort bzw. das der einzelnen Zelle des CAM-Speichers DSK zuzuführende Bit des externen Datenworts liefernden Informationsquelle aufgenommen und in die Zellen der angewählten Matrixzeile $Z_i$ eingespeichert. Im Lesemodus werden Daten aus dem adressierten Speicherwort auf den Ausgabedaten-Bus geschaltet.

Jedes der P eingabedaten-Bus-Bits besitzt einen eigenen Maskiereingang, der mit seinem Aktiv-Pegel im Vergleichsmodus eine Maskierung des betreffenden Bits für alle N Worte, die im CAM-Speicher DKS gespeichert sind, bewirkt.

Die entsprechenden IDB- bzw. $\overline{IDB}$-Leitungen liegen demgemäß am Pegel logisch "0". Die zu suchende, aus M Worten bestehende Datenkette mit M $\leq$ N wird - beginnend mit Adresse "0" (also der ersten Zeile $Z_o$ der Matrix DKS)- wortweise in M aufeinanderfolgende Zeilen der insgesamt vorgesehenen N-Zeilen der Matrix DKS abgespeichert. Die höchste Adresse ist dabei "M-1". Dabei wird das die Speicherworte über einen Adreß-Dekoder AD mit den Ausgängen $D_i$ (i = 1, 2,...N-1) adressierende Adreß-Register AR nach dem Einschreiben eines Datenwortes automatisch inkrementiert.

Nachdem alle zur zu suchenden Datenkette gehörenden Datenworte in die Matrix DKS eingeschrieben sind, ist der Inhalt des Adreß-Registers gleich der Länge M der zu suchenden Datenkette. Dies bedeutet, daß die Länge M der Datenkette nicht explizit abgespeichert werden muß. Der Ausgang $D_i$ mit i = M, also der Ausgang $D_M$, hat ab diesem Zeitpunkt Aktiv-Pegel, während alle anderen Ausgänge $D_i$ des Adreß-Dekoders AD inaktiv sind. Während des sich nun anschließenden Suchvorgangs wird der Betriebszustand des Adreß-Registers AR nicht verändert.

Beim Suchvorgang wird ein externes Datenwort aus dem zu untersuchenden Datenstrom gleichzeitig mit den in der Matrix DKS gespeicherten M Datenworten verglichen. Die Ausgänge $KZ_i$ der einzelnen Zeilen $Z_i$ der Matrix DKS werden durch die aus Fig. 4 ersichtliche Ausgangslogik AL zu einer speziellen N-stelligen Kombination der Schieberegisterzellen $S_o$ bis $S_{M-1}$ geführt, wobei zu Beginn des Suchvorgangs alle Registerzellen $S_i$ durch ein gemeinsames Resetsignal in den inaktiven Zustand versetzt worden sind.

Die Schieberegisterzellen $S_i$ werden durch eine Taktfolge DG getaktet, wobei zweckmäßig die Impulse dieser Taktfolge DG zugleich das "Daten-Gültig"-Signal des zu untersuchenden externen Datenstromes Darstellen. Die Ansteuerbedingungen für die einzelnen Schieberegisterzellen $S_o$ bis $S_{N-1}$ werden gemäß

$$S_o := KZ_o \quad \text{und} \quad S_i : S_{i-1} \quad KZ_i$$

festgelegt, wobei i = 1, 2,....N-1 ist.

Zusätzlich wird jeder mit dem Ausgang $D_i$ des Adreß-Dekoders AD über je eines der UND-Gatter $A_i$ UND-verknüpfte Ausgang der vorgesehenen Schieberegisterzellen $S_o$ bis $S_{N-1}$ als Eingang auf das NOR-Gatter NOR geführt.

Eine zu suchende Datenkette ist dann gefunden, wenn der Ausgang des NOR-Gatters NOR auf den Pegel "0" geht. Das ist immer dann der Fall, wenn der Ausgang $D_i$ des Adreß-Dekoders AD UND-verknüpft mit dem Ausgang der steuernden Schieberegisterzelle $S_{i-1}$ den Pegel "1" annimmt, nachdem i-1 aufeinanderfolgende Vergleichshoperationen mit i-1 Datenworten aus dem zu untersuchenden Datenstrom unmittelbar vorher erfolgreich gewesen waren. Dabei ist i = M zu setzen.

Mit diesem Verfahren können beliebige Datenströme untersucht werden, wobei spezielle Steuerzeichen der zu untersuchenden Datenströme entbehrlich sind. Ein Null-Signal am Ausgang des NOR-Gatters NOR kann z.B. als Interrupt an einen Prozessor gegeben werden und in diesem entsprechende Reaktionen veranlassen.

Zu bemerken ist noch, daß in dem in Fig. 4 dargestellten Ausführungsbeispiel die Ausgangslogik AL auf den Fall abgestimmt ist, daß die einzelnen Zellen der Matrix DKS als Exklusiv-ODER-Gatter betrieben werden. Sollen die Zellen hingegen als Äquivalenzgatter betrieben werden, so muß die Logik AL sinngemäß abgeändert werden, um die soeben beschriebene Betriebsweise zu ermöglichen.

Da man in diesem Falle an den Ausgängen $KZ_i$ derjenigen Zellen $Z_i$ nur dann eine "1" erhält, wenn der Vergleich zwischen dem in der betreffenden Matrixzeile $Z_i$ eingespeicherten Datenworts mit externen Datenwort positiv ist, liegen hier gerade die umgekehrten Verhältnisse gegenüber dem soeben beschriebenen Fall vor.

Hinsichtlich der Ausgestaltung gemäß Fig. 4 ist noch auf folgende, den Ausgang der letzten Schieberegisterzelle $S_{N-1}$ betreffende Sachlage hinzuweisen: Der Ausgang dieser letzten Schieberegisterzelle $Z_{n-1}$ ist nämlich an den einen Eingang eines zusätzlichen UND-Gatters $A_N$ gelegt, dessen Ausgang ebenfalls zur Steuerung des Ausgangs-NOR-Gatters NOR vorgesehen ist. Der andere Eingang dieses zusätzlichen UND-Gatters $A_N$ wird durch ein vom Adreß-Dekoder AD über einen besonderen diesem UND-Gatter $A_N$ zugeteilten Ausgang $D_N$ geliefertes Signal gesteuert. Ein zusätzliches UND-Gatter aus der Gruppe der UND-Gatter $U_i$ ist hingegen aus verständlichen Gründen nicht vorgesehen.

Zu bemerken ist schließlich, daß die anhand der Figuren 2 und 3 gegebene Ausgestaltung der kombinierten Speicher-Komparatorzellen sehr vorteilhaft aber nicht zwingend ist. So können die Zellen auch in Bipolartechnik hergestellt werden, wobei die einzelnen Bipolartransistoren, soweit sie Schaltfunktionen haben, über ihre Basis gesteuert sind, während anstelle der Lasttransistoren entweder Widerstände oder Dioden bevorzugt verwendet werden. Die monolitische Integrierbarkeit der einzelnen Speicher-Komparatorzellen gemäß der Erfindung ist klar ersichtlich, die monolithische Integrierbarkeit der im Blockschaltbild angegebenen Schaltungsteile ist allgemein bekannt.

4 Figuren

11 Patentansprüche

Patentansprüche

1. Monolithisch integrierbare digitale Komparatorschaltung zum Vergleich von extern in die Schaltung eingegebenen Digitalsignalen mit in einem zu der Schaltung gehörenden Matrixspeicher festgehaltenen Digitalsignalen und einem den Vergleich vornehmenden Komparator, dadurch gekennzeichnet, daß die in an sich bekannter Weise als einander gleiche bistabile Kippstufen ausgebildeten Speicherzellen des Matrixspeichers (DKS) jeweils mit je einem eine Komparatorzelle bildenden Schaltungsteil (T9, T10, T7, T8) kombiniert sind und daß die Signalausgänge (KA) der Komparatorzellen der einzelnen Matrixzeilen ($Z_i$) jeweils an einen gemeinsamen, der betreffenden Matrixzeile jeweils zugeordneten Signalausgang ($KZ_i$) der auf diese Weise erhaltenen Speicher-Komparator-Kombination gelegt ist.

2. Komparatorschaltung nach Anspruch 1, dadurch gekennzeichnet, daß der den Speicherinhalt der einzelnen Zelle der Speicher-Komparator-Kombination (DKS) anzeigende Signalausgang (Q) und der den invertierten Speicherinhalt anzeigende Signalausgang ($\overline{Q}$) des die bistabile Kippstufe bildenden Teils (T1, T2, T3, T4) der betreffenden Zelle je eines MOS-Feldeffekttransistors (T7,T8) vom Anreicherungstyp gelegt ist, daß dabei die beiden MOS-Feldeffekttransistoren (T7, T8) bezüglich ihrer Source-Drainstrecken hintereinander geschaltet sind und die Verbindung zwischen den beiden der betreffenden Matrixzeile ($Z_i$) zugeteilten Bitleitungen (BL) bilden, daß ferner eine zwischen den beiden MOS-Feldeffekttransistoren (T7, T8) liegender Schaltungspunkt zur Beaufschlagung eines durch dieselben Betriebspotentiale ($V_{DD}$,$V_{SS}$) wie die bistabile Kippstufe betriebenen Inverters (T9, T10) vorgesehen und der Signalausgang (KA) dieses Inverters zusammen mit den Ausgängen der Inverter der restlichen Zellen in der betreffenden Matrixzeile ($Z_i$) an einen gemeinsamen Ausgang ($KZ_i$) gelegt ist.

3. Vorrichtung nach Anspruch 1 oder 2, dadurch gekennzeichnet, daß die Inverter der Zellen der einzelnen Matrixzeilen ($Z_i$) unter Verwendung nur eines einzigen Lastwiderstandes (T10) zu einem - den Vergleichsausgang ($KZ_i$) der betreffenden Matrixzeile ($Z_i$) bildenden-NOR-Gatter zusammengefaßt sind.

4. Vorrichtung nach einem der Ansprüche 1 bis 3, dadurch gekennzeichnet, daß den einzelnen Spalten der Matrix jeweils vier Bit-Leitungen und jeweils zwei zeilenparallel verlaufende Auswahlleitungen (WL) zugeteilt sind.

5. Vorrichtung nach einem der Ansprüche 1 bis 4, dadurch gekennzeichnet, daß jede Zeile der Matrix (DKS) mittels eines Adreß-Dekoders (AD) durch je ein der betreffenden Matrixzeile ($Z_i$) zugeordnetes Adressiersignal ($D_i$) für sich adressierbar ist, daß ferner die jeweils zu vergleichende externe Dateninformation sowohl in normalem als auch in invertiertem Zustand an je eine der zur Beaufschlagung der einzelnen Matrixspalten zugeteilten Bit-Leitungen (IDB, $\overline{IDB}$) gelegt ist und daß schließlich der Vergleichsausgang ($KZ_i$) der einzelnen Matrixzeilen ($Z_i$) an je einen Eingang einer Auswerte-Logik (AL) gelegt sind.

6. Vorrichtung nach einem der Ansprüche 1 bis 5, dadurch gekennzeichnet, daß der den direkten Zustand der in den einzelnen Zellen der Matrix (DKS) jeweils gespeicherten Information anzeigende Ausgang (Q) der einzelnen Zelle mit der die externe Vergleichsinformation in direktem Zustand führenden Bit-Leitung (IDB) einerseits und der den invertierten Zustand der in den einzelnen Zellen gespeicherten Information anzeigende Ausgang ($\overline{Q}$) der einzelnen Zelle ($Z_i$) mit der die externe Vergleichsinformation in invertiertem Zustand führenden Bit-Leitung ($\overline{IDB}$) über je einen MOS-Feldeffekttransistor (T5,T6) verbunden ist, daß dabei die Gates der zuletzt genannten beiden MOS-Feldeffekttransistoren gemeinsam über eine zeilenparallel verlaufende Auswahlleitung (WL) gesteuert sind,so daß der Vergleich zwischen der gespeicherten Information und der externen Information gemäß einer Exklusiv-ODER-Funktion abläuft.

7. Vorrichtung nach Anspruch 6, dadurch gekennzeichnet, daß in der Auswerte-Logik (AL) den einzelnen Vergleichsausgängen ($KZ_i$) der Speicher-Komparator-Matrix (DKS) je eine Schieberegisterzelle ($S_i$) und je zwei UND-Gatter mit je zwei Eingängen - lediglich mit Ausnahme des der ersten Matrixzeile ($Z_o$) zugeordneten Vergleichsausgang ($KZ_o$) - zugeordnet sind, daß dabei der der ersten Matrixzeile ($Z_o$) zugeordnete Vergleichsausgang ($KZ_o$) mit dem Dateneingang einer ihm zugeordneten Schieberegisterzelle ($S_o$) im Gegensatz zu den übrigen Vergleichsausgängen ($KZ_1$ - $KZ_{N-1}$) der Matrix (DKS) unmittelbar verbunden ist, während die den übrigen Vergleichsausgängen ($KZ_1$ - $KZ_{N-1}$) jeweils zugeordneten Schieberegisterzellen ($S_i$) ausschließlich durch je ein UND-Gatter ($U_i$) gesteuert sind, das seinerseits durch den ihm zugeordneten Vergleichsausgang der Matrix ($KZ_i$) und andererseits durch den Datenausgang derjenigen Schieberegisterzelle ($S_{i-1}$) gesteuert ist, das dem benachbarten, niedriger nummerierten Vergleichsausgang ($KZ_{i-1}$) jeweils zugeordnet ist.

8. Vorrichtung nach Anspruch 7, dadurch gekennzeichnet, daß in der Auswerte-Logik (AL) jeder der unmittelbar zur Beaufschlagung eines UND-Gatters ($U_i$) vorgesehenen Vergleichsausgänge ($KZ_i$) der Speicher-Komparator-Matrix (DKS) mit dem einen Eingang dieses UND-Gatters ($U_i$) verbunden ist, daß dabei der andere Eingang dieses UND-Gatters ($U_i$) mit dem einen Eingang des zweiten, dem betreffenden Vergleichsausgang ($KZ_i$) jeweils zu-

geordneten UND-Gatters ($A_i$) verbunden ist und außerdem unmittelbar durch den Ausgang der dem jeweils benachbarten, niedriger nummerierten Vergleichsausgang ($KZ_{i-1}$) jeweils zugeordneten Schieberegisterzelle ($S_{i-1}$) gesteuert wird, daß ferner der zweite Eingang jedes auf diese Weise von einer Schieberegisterzelle ($S_{i-1}$) gesteuerten UND-Gatters ($A_i$) ausschließlich durch ein Signal ($D_i$) gesteuert ist, welches von dem die Auswahl der zu dem betreffenden Vergleichsausgang ($KZ_i$) gehörenden Matrixzeile ($Z_i$) bewirkenden Ausgang ($D_i$) des Adreß-Dekoders (AD) geliefert wird, und daß schließlich die Ausgänge dieser durch je eine der Schieberegisterzellen ($S_i$) gesteuerten UND-Gatter ($A_i$) mit je einem Eingang eines den Ausgang der Auswerte-Logik darstellenden NOR-Gatters (NOR) verbunden sind.

9. Vorrichtung nach Anspruch 7 oder 8, dadurch gekennzeichnet, daß die Schieberegisterzellen ($S_i$) durch einen gemeinsamen Takt (DG) gesteuert sind.

10. Vorrichtung nach einem der Ansprüche 7 - 9, dadurch gekennzeichnet, daß die Schieberegisterzellen ($S_i$) als einander gleiche Master-Slave-Flip-Flops ausgebildet sind.

11. Vorrichtung nach einem der Ansprüche 7 - 10, dadurch gekennzeichnet, daß der Ausgang der dem letzten Vergleichsausgang ($KZ_{N-1}$) der Speicher-Komparator-Matrix (DKS) zugeordneten Schieberegisterzelle ($Z_{N-1}$) lediglich mit dem Eingang eines weiteren, zur Beaufschlagung des Ausgangs-NOR-Gatters (NOR) vorgesehenen UND-Gatters ($A_N$) verbunden ist, daß zur Steuerung des zweiten Eingangs dieses zusätzlichen UND-Gatters ($A_N$) ein besonderes Signal ($D_N$) vorgesehen ist, welches von einem diesem UND-Gatter ($A_N$) zugeordneten Ausgang ($D_N$) des Adreß-Dekoders (AD) geliefert wird.

FIG 1

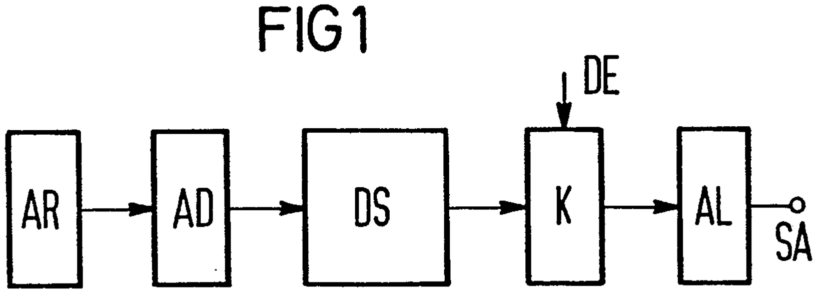

DE
AR
AD
DS
K
AL
SA


FIG 2

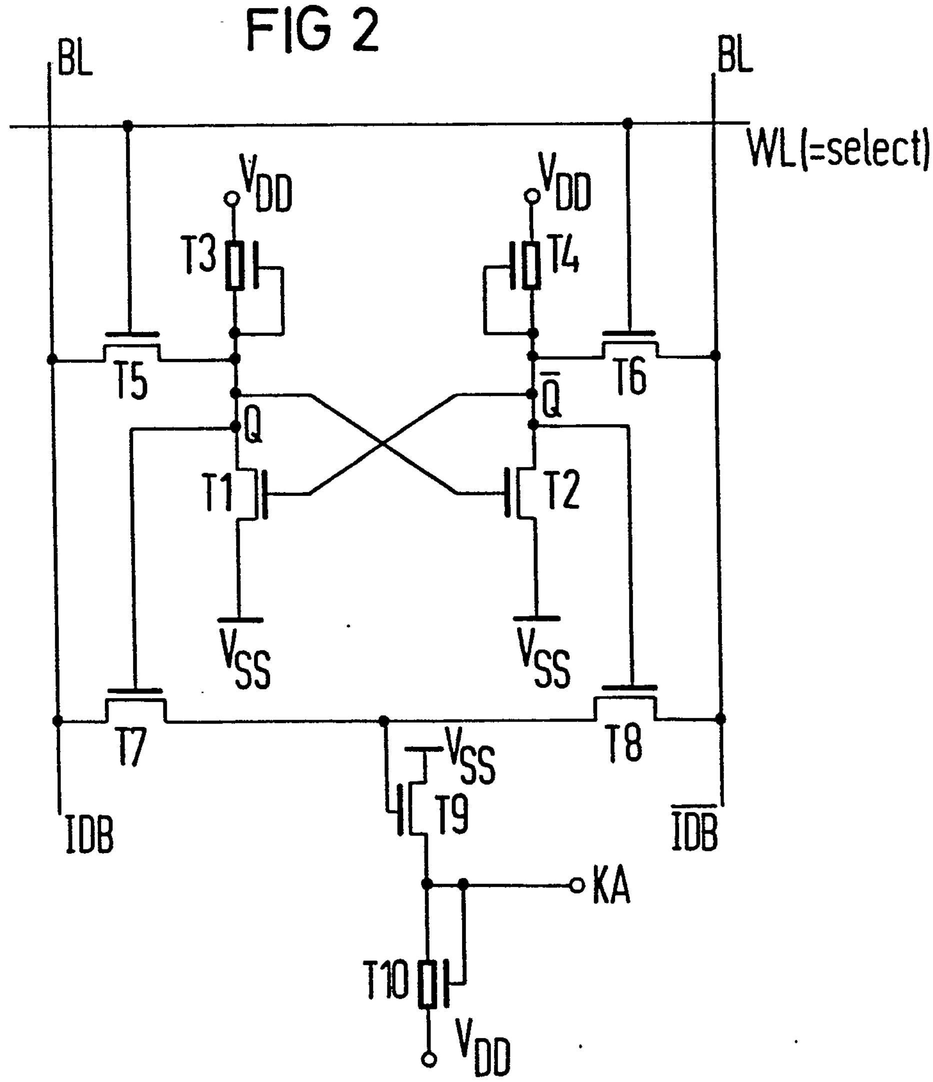

BL
BL
WL (=select)
$V_{DD}$
$V_{DD}$
T3
T4
T5
T6
Q
$\overline{Q}$
T1
T2
$V_{SS}$
$V_{SS}$
T7
T8
$V_{SS}$
T9
IDB
$\overline{IDB}$
KA
T10
$V_{DD}$

FIG 3

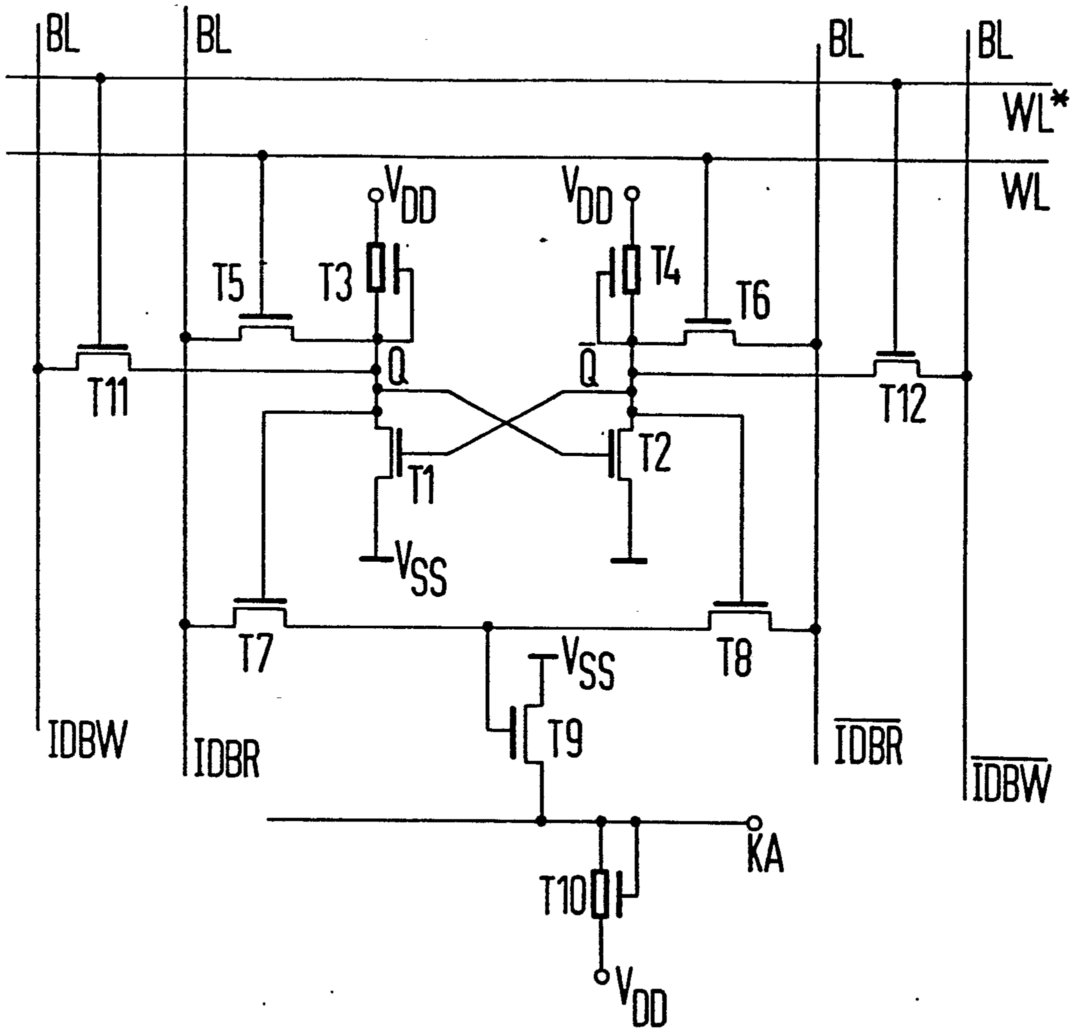
BL
BL
BL
BL
WL*
WL
$V_{DD}$
$V_{DD}$
T5
T3
T4
T6
Q
$\overline{Q}$
T11
T12
T1
T2
$V_{SS}$
T7
T8
$V_{SS}$
T9
IDBW
IDBR
$\overline{IDBR}$
$\overline{IDBW}$
KA
T10
$V_{DD}$

FIG 4

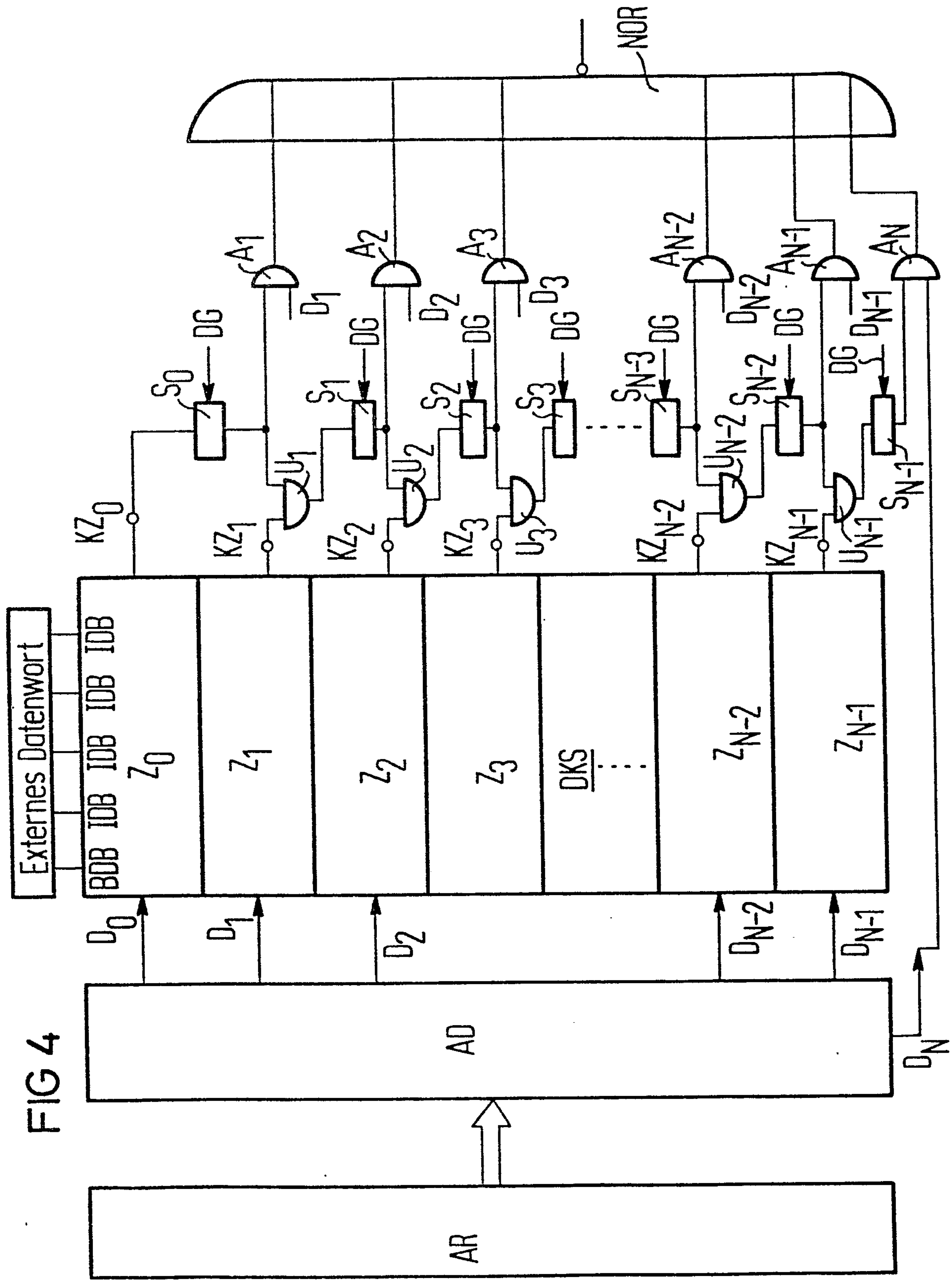

0039800

Europäisches Patentamt

# EUROPÄISCHER RECHERCHENBERICHT

Nummer der Anmeldung
EP 81 10 2967

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | THE ELECTRONIC ENGINEER, Band 29, Nr. 8, August 1970, Seiten 54-56 Chilton Co. Radnor, U.S.A. L.D. WALD: "MOS associative memories" * Seite 55, linke Spalte, Zeile 12 - Seite 56, rechte Spalte, Zeile 21; Figur 1 * -- | 1-3,5, 6 | G 11 C 15/00 |
| | US - A - 3 633 182 (BELL TELEPHONE LABORATORIES) * Spalte 2, Zeile 19 - Spalte 4, Zeile 60; Figuren 1-3 * -- | 1-6 | RECHERCHIERTE SACHGEBIETE (Int. Cl.³) G 11 C 15/00 |
| | US - A - 3 693 170 (MARCONI COMPANY LTD.) * Spalte 2, Zeile 23 - Spalte 5, Zeile 11; Figuren 1,2 * -- | 1-6 | |
| | IBM TECHNICAL DISCLOSURE BULLETIN, Band 12, Nr. 9, Februar 1970, Seite 1477 New York, U.S.A. R.J. LLEWELYN: "Next and previous latches" * Insgesamt * -- | 7 | KATEGORIE DER GENANNTEN DOKUMENTE<br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument<br>L: aus andern Gründen angeführtes Dokument |
| | US - A - 3 290 659 (BUNKER-RAMO) * Spalte 5, Zeile 10 - Spalte 6, Zeile 25; Figuren 1,2 *. ---- | 7 | |
| X | Der vorliegende Recherchenbericht wurde für alle Patentansprüche erstellt. | | &: Mitglied der gleichen Patentfamilie, übereinstimmendes Dokument |

| Recherchenort | Abschlußdatum der Recherche | Prüfer |
|---|---|---|
| Den Haag | 21-08-1981 | DEGRAEVE |

EPA form 1503.1 06.78